# EUROPEAN PATENT SPECIFICATION

(11) **EP 2 907 167 B1**
(45) Date of publication and mention of the grant of the patent: **29.11.2017**
(21) Application number: 13756681.6
(22) Date of filing: 17.06.2013
(51) Int. Cl.: H01L 31/05

(54) **BACK-CONTACT BACK-SHEET FOR PHOTOVOLTAIC MODULES COMPRISING A PRIMER LAYER**
RÜCKSEITENKONTAKTFOLIE FÜR PHOTOVOLTAIKMODULE MIT EINER GRUNDIERUNGSSCHICHT
FEUILLE ARRIÈRE DE CONTACT ARRIÈRE POUR MODULES PHOTOVOLTAÏQUES COMPRENANT UNE COUCHE DE FOND

(30) Priority: 10.10.2012 IT VI20120264
(43) Date of publication of application: 19.08.2015
(73) Proprietor: Ebfoil S.r.l., 40124 Bologna (IT)
(72) Inventor: BACCINI, Elisa, I-31030 Carbonera (TV) (IT); MARRAS, Luigi, I-34076 Medea (GO) (IT); BUCCI, Bruno, I-40055 Castenaso (BO) (IT)
(74) Representative: Grünecker Patent- und Rechtsanwälte PartG mbB
(86) International application number: PCT/IB2013/054953
(87) International publication number: WO 2014/057367

(56) References cited:
- WO-A1-2012/169550
- WO-A2-2012/135395
- JP-A- 2011 199 020
- US-A- 5 972 732
- Hanita Coatings: "DuraShield Back-Contact Sheets", , 13 June 2012 (2012-06-13), XP002712000, Retrieved from the Internet: URL:http://www.hanitaenergy.com/sites/hani ta/UserContent/files/PV%20PDF/PV_BACKCONTA CT_page_v5.pdf [retrieved on 2013-08-28]

## Description

### TECHNICAL FIELD OF THE INVENTION:

The present invention relates to the field of photovoltaic modules. In particular, the present invention relates in particular to innovative back-contact back-sheets for a photovoltaic module wherein back-contact photovoltaic cells are included.

Yet more in detail, the present invention relates to a back-contact back-sheet comprising a primer layer applied to the inner face of the back-contact back-sheet, such as to improve adhesion between the inner face and an encapsulating material layer or a multi-layered structure applied to the inner face of the back-contact back-sheet.

### STATE OF THE ART

Solar cells are used for converting solar light into electrical energy by means of the photovoltaic effect. Solar cells are, thus, one of the most promising alternative energy sources for replacing fossil fuels. Solar cells are formed by semiconductor materials and assembled so as to form so called photovoltaic modules, which are in turn grouped in order to form photovoltaic plants to be typically installed on building roofs or the like.

In order to form a photovoltaic module, groups of solar cells, grouped in series through appropriate electrical conductors called "ribbons", are typically encapsulated by means of an encapsulating material such as a copolymer of ethylene and vinyl acetate, commonly known as EVA. The encapsulating material enclosing the solar cells is then inserted between a surface layer and a base layer or back-sheet, so as to complete the photovoltaic module.

The surface layer, or main surface of the module, typically made of glass, covers the surface of the module exposed to the sun and allows the solar light to reach the cells. On the other hand, the back-sheet carries out a multiplicity of tasks. It guarantees protection of the encapsulating material and of the solar cells from environmental agents, while simultaneously preventing the electrical connections from oxidizing. In particular, the back-sheet prevents moisture, oxygen and other factors depending on the atmospheric conditions from damaging the encapsulating material, the cells and the electrical connections. The back-sheet also provides for electrical insulation for the cells and the corresponding electrical circuits. Furthermore, the back-sheet has to have a high degree of opacity due to esthetic reasons and high reflectivity in the part oriented toward the sun for functional reasons.

The electrical connection in photovoltaic modules comprising traditional solar cells occurs on both the front and the rear side of the cell. Back-contact cells are a new, more efficient and cost-effective generation of photovoltaic cells, wherein the contacts with both electrodes of the cell are transferred to the rear side of the cell, i.e. onto the side not exposed to the light radiation. Metallization Wrap Through (MWP) cells turn out to be particularly efficient and easy to implement. In MWT cells, the contact to the front electrode is transferred to the rear side of the back cell by means of a through-hole extending across the thickness of the semiconductor substrate.

Back-contact cells pose new technological problems concerning the design and the structure of the modules adapted to accommodate them. For example, the back-sheet has to be designed so as to support a connecting circuit which is brought into electrical contact with the ohmic contacts formed on the rear side of the cell. These ohmic contacts are connected to both electrodes (base and emitter) of the cell. One of the solutions to this problem is the so called back-contact back-sheet, which is an evolution of the traditional back-sheet, wherein the connecting circuit is implemented directly on the surface of the back-sheet facing the cell.

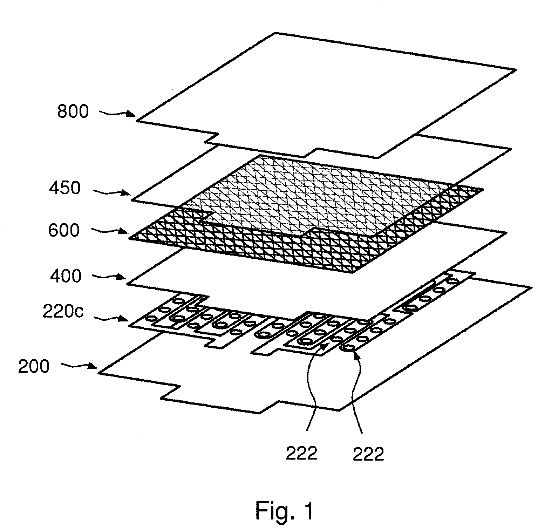

In Figure 1 the structure of a photovoltaic module comprising back-contact solar cells is shown.

Back-contact cell 600 is arranged between an upper encapsulating material layer 450 and a lower encapsulating material layer 400. Cell 600 and encapsulating material layers 400 and 450 are then enclosed between a surface layer 800 typically made of glass or of a transparent and antireflective material and the back-sheet 200, which may be a back-contact back-sheet.

In figure 1 there are visible the paths of electrically conductive material making up the connecting circuit 220c to the electrodes of the solar cell. If back-sheet 200 is a back-contact back-sheet, the connecting circuit is formed directly on the surface of the lower-lying insulating substrate and is firmly fixed thereto. The connecting circuit 220c is used so as to ensure an electrical contact with both electrodes (i.e. with the base and the emitter) of solar cell 600. In particular, the paths of electrically conductive material are provided with pads 222 marking the points of the connecting circuit which are to be electrically connected with a contact to one of the electrodes formed on the rear surface of cell 600.

The procedure of assembling a photovoltaic module such as that shown in Figure 1 is typically performed in the manner described in the following.

The lower encapsulating material layer 400 to be arranged between the cell 600 and the back-contact or back-contact back-sheet 200 is pierced so that, after the module has been completed, the holes formed in the lower encapsulating layer 400 correspond to areas where pads 222 for contact with the electrodes are arranged.

The pierced encapsulating material layer 400 is then laid on top of the inner face of back-sheet or back-contact back-sheet 200, i.e. onto the face back-sheet or back-contact back-sheet 200 exposed toward the inside of the photovoltaic module. When applying lower encapsulating material layer 400, the encapsulating material foil is aligned to back-sheet or back-contact back-sheet so that the holes in lower encapsulating material layer 400 correspond or are aligned to pads 222. In this manner, pads 222 are left exposed toward the outside of the photovoltaic module.

A lump or drop of an electrically conductive material is then deposited onto pads 222 of the conductive paths of the connecting circuit formed on the surface of the back-sheet or of the back-contact back-sheet 200. The surface of pads 222 is left exposed by the holes of the lower encapsulating material layer 400. The conductive material deposited onto pads 222 may for example comprise a conductive paste of the type knows as "Electro Conductive Adhesive" (ECA).

Subsequently, the cells 600 to be embedded in the module are placed onto the lower encapsulating material layer 400 so that each contact element with the electrodes formed on the rear surface of the cells comes into contact with a lump of conductive paste applied to one of the pads 222 and exposed to the contact with cells 600 through one of the holes of the lower encapsulating material layer 400. The upper encapsulating material layer 450 is then placed onto the upper surface of the cell 600, opposite the rear surface in contact with the conductive paste applied to pads 222. Finally, a layer 800 of a transparent and antireflective material is laid onto the upper encapsulating material layer 450.

After the structure has been prepared as described above, this can be turned upside down and subsequently laminated in vacuum at a temperature between 145 °C and 165 °C for a time interval variable between 8 and 18 minutes.

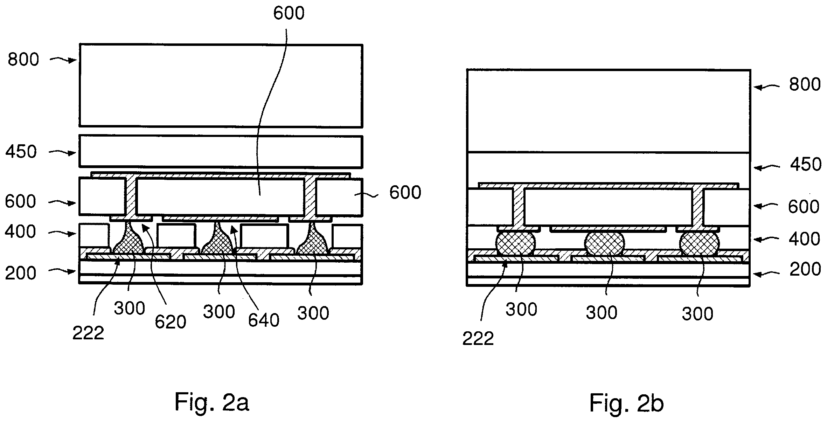

Figure 2a shows the structure of the module before the lamination process. The components of the module, stacked as previously described, are singularly distinguishable. In particular, Figure 2a shows a stack comprising, starting from the bottom and moving towards the top of the figure, the back-sheet or back-contact back-sheet 200 with conductive pads 222 upon which conductive paste 300 has been applied, the lower encapsulating material layer 400, cells 600, the upper encapsulating material layer 450 and surface layer 800.

The electrical connection to the electrodes (base and emitter) of cell 600 is guaranteed by contact points 620 and 640 formed on the rear side of cell 600, i.e. on the side facing connecting circuit 220c and back-sheet 200. Contact points 620 and 640 may be connected to the positive and negative electrode of the photovoltaic cell, respectively.

Figure 2b schematically shows the structure of the module after the lamination process has taken place. During the first lamination stage, the structure is arranged into a vacuum chamber from which the air is evacuated by means of pumps. A pressure is then applied to the structure so as to compact the layers of which the photovoltaic module structure is comprised while simultaneously maintaining a vacuum in the area in which the module is situated. The whole cycle has preferably a total duration less then 18 minutes. The cycle preferably occurs at a temperature between 140 °C and 165 °C.

The lamination results in the hardening of the conductive paste 300 through its polymerization, thus causing cells 600 to attach to back-sheet 200. Furthermore, a task of the lamination process is also causing melting and subsequent polymerization of the upper and lower encapsulating material layers 450 and 400. In this manner, the encapsulating material of the lower layer 400, by melting, fills all void spaces between the conductive paste 300, the back-sheet or back-contact back-sheet 200 and the rear surface of cells 600. Furthermore, after polymerizing, the upper encapsulating material layer 450 exerts also an adhesive action between the surface layer 800 and outer surface of cell 600 in contact with upper encapsulating material 450. Analogously, the lower encapsulating material layer 400, after polymerizing, exerts also an adhesive action between the rear surface of cells 600 and back sheet 200.

As an alternative to the lower encapsulating layer 400, a multi-layered structure may be used, whose upper layer exerts an encapsulating action and whose lower layer provides for adhesion of the structure to the inner face of the back-contact back-sheet.

The lower layer of the multi-layered structure or the encapsulating/thermo-adhesive layer interposed between the lower face of the cells and the back-sheet are thus responsible for the adhesion to the inner surface of the back-contact back-sheet onto which they are applied.

In order to achieve this goal, a material and a procedure must be found which allow for a steady adhesion of the multi-layered structure or of the lower encapsulating layer with both the connecting circuit 220c and the surface portion of the substrate left exposed by the connecting circuit. This surface portion of the substrate left exposed by connecting circuit to 220c typically comprises a polymeric material such as, for example, polyvinyl fluoride (PVF), polyvinylidene fluoride (PVDF), polyethylene terephtalate (PET), polyethylene (PE), or polyethylene naphtalate (PEN).

Causing the multi-layered structure or a single foil of an encapsulating material to adhere across the whole inner face of the back-contact back-sheet onto which they are applied is in general not a trivial task. Indeed, thermo-adhesive or encapsulating materials used as main components of the multi-layered structure or of the lower encapsulating material foil 400 display a fair adhesion to the metal of connecting circuit 220c but adhere much less steadily to the exposed surface of the substrate of the back-contact back-sheet not occupied by the connecting circuit.

Hanita Coatings "DuraShield Back-Contact Sheets", retrievable from http://www.hanitaenergy.com/sites/hanita/UserContent/files/PV%20PDF/PV BACKCONTACT p age v5.pdf describes a back-contact back-sheet for back-contact solar cells comprising an insulating layer in PET, an adhesive layer, and an aluminium layer.

In view of the problems and drawbacks previously described, it is an object of the present invention to provide a back-contact back-sheet with an inner face capable of strongly adhering to an encapsulating or thermo-adhesive material layer which may be applied thereupon and a method of implementing such a back-contact back-sheet.

In particular, it is an object of the present invention to provide a back-contact back-sheet with an inner face, i.e. the face facing the inside of the photovoltaic module, having features of chemical compatibility with an encapsulating or thermo-adhesive material layer adapted to be applied thereupon. The inner face of the back-contact back-sheet should also guarantee a high adhesion with respect to the metallic conductive circuit, possibly by means of adhesive systems.

### BRIEF DESCRIPTION OF THE INVENTION

According to the present invention, a back-contact back-sheet for a photovoltaic module is provided as defined in claim 1. Still according to the present invention, a method of producing a back-contact back-sheet for a photovoltaic module is provided as defined in claim 7. Preferred embodiments of the present invention are provided by the dependent claims and by the following description.

### BRIEF DESCRIPTION OF THE FIGURES

Further features and advantages of the present invention will appear more clearly from the following description of the embodiments of the device and method according to the present invention show in the figures. In the figures identical and/or similar and/or corresponding parts are identified by the same references numerals or letters. In particular, in the in the figures:
Figure 1 shows an exploded view of a portion of a photovoltaic module comprising back-contact cells;
Figure 2a shows a cross-sectional view of the structure of a photovoltaic module of the type shown in Figure 1 before the lamination process;
Figure 2b shows a cross-sectional view of a photovoltaic module of the type shown in Figure 1 after the lamination process;
Figure 3 shows a cross-sectional view of a system comprising a multi-layered structure and a back-contact back-sheet before a multi-layered structure is applied to the surface of the back-contact back-sheet;
Figure 4 shows a cross-sectional view of a back-contact back-sheet according to an embodiment of the present invention.

### DETAILED DESCRIPTION

In the following, the present invention will be described with reference to particular embodiments as shown in the attached figures. However, the present invention is not restricted to the particular embodiments described in the following detailed description and shown in the figures. Rather, the described embodiments simply show several aspects of the present invention whose scope is defined by the claims.

Further modifications and variations of the present invention will be clear for the person skilled in the art. Consequently, the present description is to be considered as comprising all modifications and/or variations of the present invention, whose scope is defined by the claims.

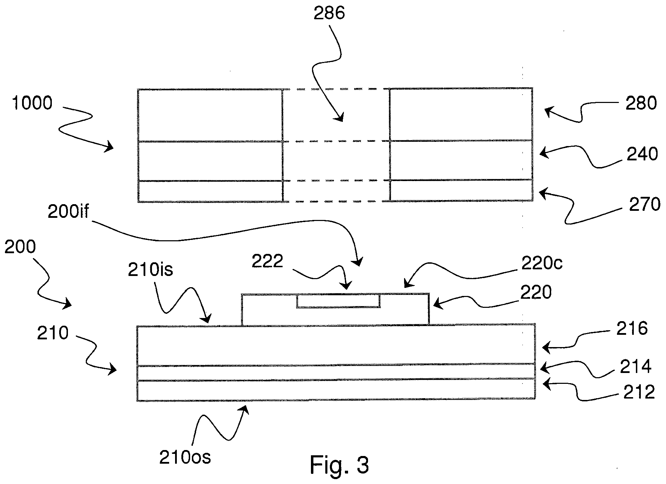

As described above, during a stage of a photovoltaic module manufacturing process, an encapsulating material layer 400 or a multi-layered structure are applied to the inner face of the back-contact back-sheet, i.e. to the face of the back-contact back-sheet facing the inside of the photovoltaic module. A multi-layered structure 1000 replacing lower encapsulating material layer 400 shown in Figure 1 will be more extensively described in the following with reference to Figure 3.

In the state of the art, multi-layered structure 1000 (Figure 3) or encapsulating material foil 400 (Figure 1) are firmly fixed to the inner face 200if of a back-contact back-sheet 200 shown in the lower part of Figure 3.

The air-side of the photovoltaic module is the side at the bottom of Figure 3, below the back-contact back-sheet 200 shown therein.

Back-contact back-sheet 200 comprises an outer face facing the air side of the photovoltaic module and an inner face 200if opposite the outer face and exposed toward the inside of the photovoltaic module.

Back-contact back-sheet 200 further comprises an insulating complex or substrate 210 exposed to the air-side of the photovoltaic module.

Insulating substrate 210 has an outer surface 210os facing the air-side of the photovoltaic module and substantially coincident with the outer face of back-contact back-sheet 200. Furthermore, substrate 210 has an inner surface 210is opposite outer surface 210os and facing the inside of the photovoltaic module.

In the embodiment of the back-contact back-sheet shown in Figure 3, insulating substrate 210 comprises a first insulating layer 212, an intermediate layer 214 and a second insulating layer 216.

The first insulating layer 212 has a surface exposed toward the air-side of the photovoltaic module and is used as a barrier against moisture, UV rays, oxygen and other external environmental agents which might penetrate into the module, thereby damaging some constituent parts thereof or causing the polyurethane-like or polyester-like adhesive to degrade and turn yellow.

The inner surface of the first insulating layer 212, opposite the surface exposed to the air-side, faces the intermediate layer 214, which acts as a barrier against moisture and water vapour. Intermediate layer 214 is typically comprised of aluminium, preferably with a thickness in the range of 8 and 25 µm.

The inner surface of intermediate layer 214, opposite the surface facing first insulating layer 212, then faces the second insulating layer 216, acting as an electrical insulator and a further barrier. Second insulating layer 216 typically comprises a polymer. According to an embodiment of the present invention, second insulating layer 216 comprises at least one of the following polymers: polyethylene terephthalate (PET), polyethylene (PE), polyvinyl fluoride (PVF), polyvinylidene fluoride (PVDF), polyethylene naphthalate (PEN), polyimide (PI) such as, for example, Kapton® or similar materials. The upper surface of second insulating layer 216, opposite the surface facing intermediate layer 214, substantially coincides with inner surface 210is of insulating substrate 210.

In an alternative embodiment of the back-contact back-sheet, insulating substrate 210 is comprised of a single layer comprising, for example, one or more polymers such as PET, PE, PVF, PVDF, PEN, PI and the like.

Thus, the inner surface 210is of insulating substrate 210 of the back-contact back-sheet is generally formed from one or more of the polymeric materials mentioned above.

An electrically conductive material layer 220 is then applied to the inner surface 210is of substrate 210 opposite the surface 210os facing the air-side, so that layer 220 is firmly fixed to inner surface 210is of substrate 210 facing the inside of the photovoltaic module. Electrically conductive material layer 220 may have a thickness approximately in the range of 25 to 70 µm. Electrically conductive material layer 220 comprises a metal with a high electrical conductivity such as for example copper or aluminium.

Electrically conductive material layer 220 is usually continuous when being applied to inner surface 210is of substrate 210. Electrically conductive material layer 220 is subsequently processed so as to form a pattern comprising in general elongated electrically conductive elements such as paths, tracks, etc. Such a pattern forms the connecting circuit 220c to the electrodes of the solar cells.

The connecting circuit 220c may be formed in electrically conductive material layer 220 by means of techniques such as optical lithography, dry or wet etch, mechanical ablation obtained for example through a milling process, laser ablation and other techniques adapted to that purpose and known to the skilled person.

Conductive material layer 220 may be processed after being applied to inner surface 210is of insulating substrate 210. Alternatively, connecting circuit 220c may be formed in conductive material layer 220 before electrically conductive material 220 is applied to inner surface 210is of substrate 210.

Connecting circuit 220c is formed so as to have surface portions forming indentations or meanders. Hence, connecting circuit 220c usually leaves exposed portions of the inner surface 210is of substrate 210 onto which it is applied.

After connecting circuit 220c has been formed in electrically conductive material layer 220, the inner face 200if of the back-contact back-sheet, opposite the face facing the air-side, thus comprises the surface of connecting circuit 220c exposed toward the inside of the photovoltaic module and the portion of inner surface 210is of substrate 210 left exposed by connecting circuit 220c. In the case of the back-contact back-sheet shown in Fig. 3, inner surface 210is of substrate 210 coincides with the surface of second insulating layer 216 facing the inside of the photovoltaic module.

Conductive layer 220 further comprises pads 222 formed in predetermined positions of the pattern of which the connecting circuit 220c is comprised. Pads 222 are adapted to be brought into electrical contact with the ohmic contacts formed on the surface of the electrodes of the solar cells by means of a lump of conductive material. The ohmic contacts are for example those indicated by reference numerals 620 and 640 in Figures 2a and 2b. Pads 222 thus ensure the electrical contact with the solar cells mounted in the photovoltaic module.

Lower encapsulating material 400 shown in Fig. 1 or multi-layered structure 1000 schematically shown in Fig. 3 may then be applied to inner face 200if of back-contact back-sheet 200.

In Fig. 3, multi-layered structure 1000 is shown during a stage of the manufacturing procedure of a photovoltaic module before being applied to back-contact back-sheet 200.

With reference to Fig. 3, multi-layered structure 1000 comprises a lower layer 270, an intermediate layer 240 and an upper layer 280. Each layer has a well-defined role.

Upper layer 280 comprises an encapsulating material which will act as a protection to the solar cells, after the photovoltaic module has been completed. Upper layer 280 may comprise at least one of the following materials: silicones, ionomers, thermo-polyurethanes, polyolefins, thermopolyolefins, acryl terpolymers with a grafting agent. The grafting agent may comprise maleic anhydride.

Intermediate layer 240, arranged directly below encapsulating material upper layer 280, is used in order to contrast the elasticity of upper layer 280 and to provide the structure with mechanical rigidity, so that structure 1000 does not deform as a result of an application of a tensile stress. Intermediate layer 240 of multi-layered structure 1000 may comprise a polymer such as PET, PP, PI, or other polymers which have a high elastic modulus and higher melting temperatures than the encapsulating material of which upper layer 280 is comprised.

Finally, lower layer 270 is responsible for the adhesion of structure 1000 to the surface of the underlying back-contact back-sheet onto which structure 1000 is applied. The material of which lower layer 270 is comprised must ensure a strong adhesion of lower layer 270 to both the surface of the electrically conductive material layer 220 and the portions of inner surface 210is of substrate 210 left exposed by conductive material layer 220. The material making up lower layer 270 must also be able to adapt to different heights of the inner face 200if of the back-contact back-sheet 200 so as to fill all voids thereof. Furthermore, lower layer 270 must melt and be sufficiently fluid at those temperatures reached in lamination processes commonly used in a photovoltaic module assembly process.

Lower layer 270 of structure 1000 or lower encapsulating material layer 400 may comprise a thermo-adhesive material such as a resin chosen among epoxy, epoxy phenolic, co-polyester, polyurethane or polyolefin ionomer resins. Alternatively, lower layer 270 or lower encapsulating material layer 400 may comprise an encapsulating material such as one of those of which upper layer 280 is comprised. Thus, lower layer 27 may comprise one or more of the following materials: EVA, silicones, ionomer resins, thermo-polyurethanes, polyolefins, thermopolyolefins, acryl terpolymers with a grafting agent.

After being produced, multi-layered structure 1000 or the encapsulating material foil 400 may be pierced so as to make a plurality of through-holes 286. Through-holes 286 are preferably in correspondence to points 620 and 640 formed on the rear side of back-contact cells 600 for ohmic contact to the electrodes of the photovoltaic cells. These contacts may for example be formed on the positive electrode (p-contact) and on the negative electrode (n-contact) of cells 600, respectively.

Thanks to the presence of intermediate layer 240, structure 1000 is substantially non-extendible, which renders the operation of piercing through-holes 286 through structure 1000 easier, quicker and more cost-effective. Through-holes 286 may be formed by means of punching, mechanical ablation obtained by milling, laser ablation, laser contouring, or other techniques known to the skilled person.

Multi-layered structure 1000 or encapsulating material foil 400, after being pierced, are aligned and applied to inner face 200if of back-contact back-sheet 200.

Through-holes 286 of multi-layered structure 1000 or of single encapsulating material foil 400 are formed so that, after multi-layered structure 1000 or encapsulating material foil 400 have been aligned to the back-contact back-sheet, the position of each through-hole 286 corresponds to the position of one of ohmic contacts 620 and 640 formed on the rear surface of the cells. Furthermore, after multi-layered structure 1000 or encapsulating material foil 400 have been aligned and applied to the back-contact back-sheet, the position of each through-hole 286 will leave exposed a respective contact pad 222 on conductive material layer 220. Contact pads 222 may thus be brought into electrical contact with ohmic contacts 640 or 620 on the rear side of cell 600 through holes 286.

After multi-layered structure 1000 or encapsulating material foil 400 have been fixed to inner face 200if of back-contact back-sheet 200, a lump 300 of an electrically conductive paste may be applied to contact pads 222 through each hole 286. Thereafter, cells 600 are laid onto multi-layered structure 1000 or onto perforated encapsulating material foil 400 and the lamination process of the photovoltaic module described above is carried out.

Fixing multi-layered structure 1000 or encapsulating material 400 of back-contact back-sheet 200 may for example be achieved by means of a hot-lamination process or through a selective laser heating in predetermined points of the system, or else by means of pure adhesive agents such as double-sided adhesive, if necessary applied in predetermined points or in a selective manner. In the case of multi layered structure 1000, adhesion to back-contact back-sheet 200 may be achieved by means of a lower layer 270 comprising a thermo-adhesive having weak properties of cold-adhesion.

During lamination, the heat provided to the system results in partial melting of lower layer 270 of structure 1000 (Figure 3) or of lower encapsulating material foil 400 (Figures 1, 2a and 2b). Lower layer 270 or encapsulating material foil 400, when melting, cause structure 1000 to attach to back-contact back-sheet 200. Furthermore, the thermo-adhesive or encapsulating material of which lower layer 270 or encapsulating material layer 400 are comprised, penetrates after melting into the interstices between adjacent paths of connecting circuit 220c of conductive material 220 (see for example Figure 2b). In this manner, layer 270 or encapsulating material layer 400 accomplish the additional task of electrically insulating adjacent paths of connecting circuit 220c which are not electrically connected. Lower layer 270 of structure 1000 or encapsulating material layer 400 also accomplish the task of neutralizing surface currents possibly flowing on inner surface 210is of insulating substrate 210 upon which conductive material layer 220 and a portion of lower layer 270 are fixed.

The majority of thermo-adhesive or encapsulating materials used in the field of photovoltaic modules, after being liquefied as a result of a heating process and being reverted to the solid state, have a good adhesion with the metal forming electrically conductive material layer 220 lying on inner face 200if of back-contact back-sheet 200. For instance, the adhesion force of a material such as EVA on copper is equal to about 35 N/cm.

However, thermo-adhesive or encapsulating materials used for lower layer 270 of multi-layered structure 1000 shown in Figure 3 or for encapsulating material layer 400 shown in Figures 1 and 2, adhere much more weakly to the portion of inner surface 210is of substrate 210 left exposed by connecting circuit 220c. As said above, the inner surface 210is of substrate 210 is usually comprised of a polymer such as PET, PE, PVF, PVDF, PEN, PI and the like. For example, the adhesion force of EVA on a PET surface is of about 2 N/cm.

In order to increase the adhesion force between lower layer 270 of multi-layered structure 1000 or a single encapsulating material foil 400 and the face of the back-contact back-sheet upon which the are applied, it has been proposed to expose inner surface 210is of substrate 210 of back-contact back-sheet 200 to a surface treatment prior to application of electrically conductive material layer 220 onto inner surface 210is. This treatment may comprise a plasma treatment or a corona treatment aimed at increasing the surface energy of inner surface 210is in order to increase its adhesiveness. Alternatively, or additionally, the surface treatment may comprise a primer applied with known techniques to inner surface 210is before being assembled into complex 210.

In the context of formation of polymer films such as for example PET films, with the term "primer" it is referred to an infinitesimal layer of the order 0.05 µm applied to the PET surface so as to modify its surface properties without significantly modifying its thickness. The primer is applied without any intermediate elements. When zhe thickness of the primer becomes significant, the "primer layer" is more appropriately used. In this case, the thickness may be of the order of tens of microns or greater. Primer layers are usually applied by means of adhesive systems.

Conductive material layer 220 is applied to inner surface 210is of substrate 210 after the surface treatment. Since conductive material layer 220 is applied onto inner surface 210is in the form of a continuous foil, it has to be processed in order to obtain connecting circuit 220c after conductive material layer 220 has been applied to inner surface 210is of substrate 210. As said above, processing techniques used for obtaining the paths forming connecting circuit 220c comprise optical lithography used for example in conjunction with a chemical etch, mechanical ablation for example by means of milling, thermo-ablation obtained for example through laser induced heating , etc. All these techniques, when used onto the conductive material layer applied on inner surface 210is, tend to eliminate or at least decrease the effect of the surface treatment previously carried out onto inner surface 210is of substrate 210. In particular, none of the techniques used for forming connecting circuit 220c in electrically conductive material layer 220 allow desired portions of conductive material layer 220 to be removed with a degree of precision sufficient to prevent the portion of inner surface 210is of substrate 210 affected by the surface treatment from being damaged when processing conductive material layer 220.

An example may better clarify the technical problem. It should be remembered that conductive material layer 220 has preferably a thickness in the range of about 25 to about 75 µm. Furthermore, the layer of inner surface 210is of substrate 210 across which the surface treatment is effective extends by a thickness much less than 1 µm. Let us suppose for example of operating by means of a mill onto conductive material layer 220 fixed to substrate 210 so as to remove predetermined portions thereof and to form connecting circuit 220c. In this case, it is extremely hard to adjust the precision of the mill so as to form through-channels in conductive material layer 220 without simultaneously removing also portions of inner surface 210is in direct contact with conductive material layer 220. Due to the precision of a typical milling apparatus, the portion of inner surface erroneously removed will have a thickness equal to or greater than 1 µm. An analogous problem is to be faced when operating with other techniques for forming connecting circuit 220c using, for example, laser ablation or chemical wet or dry etching.

In order to overcome these problems, an improved back-contact back-sheet and a method of production thereof are here proposed.

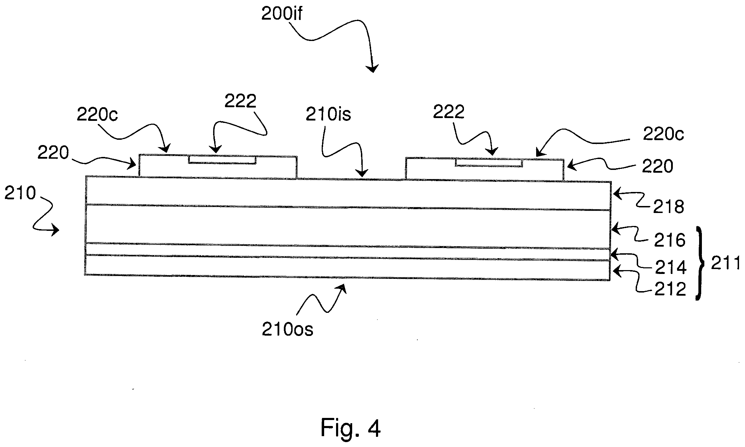

Back-contact back-sheet 200 according to an embodiment of the present invention is shown in Figure 4.

Analogously to the back-contact back-sheet described with reference to Figure 3, the back-contact back-sheet according to the present invention comprises a substrate 210 and an electrically conductive material layer 220.

In particular, substrate 210 has an outer surface 210os facing the air-side of the photovoltaic module and substantially coincident with the outer face of the back-contact back-sheet. Furthermore, substrate 210 has an inner surface 210is opposite outer surface 210os and facing the inside of the photovoltaic module.

The substrate 210 of the back-contact back-sheet according to the present invention comprises a lower insulating portion 211 and a primer layer 218.

Insulating portion 211 comprises a lower surface exposed towards the air-side of the photovoltaic module and substantially coincident with outer surface 210os of substrate 210. Insulating portion 211 further comprises an upper surface opposite the lower surface.

According to the embodiment of the present invention shown in Figure 4, lower insulating portion 211 comprises a first insulating layer 212, an intermediate layer 214 and a second insulating layer 216.

First insulating layer 212 has a surface exposed to the air-side of the photovoltaic module and is used as a barrier against moisture, UV rays, oxygen and other external agents which might penetrate into the module thereby damaging some constituent parts thereof or causing the polyurethane-like or polyester-like adhesive to degrade and turn yellow. First insulating layer 212 may comprise a polymer such as polyvinyl fluoride (PVF), polyvinylidene fluoride (PVDF), polyethylene terephtalate (PET), polyethylene (PE), or other polymers. The first insulating layer 212 may have a thickness in a range of approximately 25 to 75 µm or greater.

The upper surface of first insulating layer 212, opposite the surface exposed to the air.side, faces the intermediate layer 214, which acts as a barrier against moisture and water vapor. Intermediate layer 214 is typically made from a material non transparent to water vapor, such as for example aluminum. Intermediate layer 214 has a thickness preferably in the range of 8 to 25 µm.

The upper layer of intermediate layer 214, opposite the surface facing the first insulating layer 212, faces the second insulating layer 216 which acts as an electrical insulator and a further barrier. Second insulating layer 216 typically comprises a polymer such as, for example, polyethylene terephtalate (PET), polyethylene (PE), polyvinyl fluoride (PVF), polyvinylidene fluoride (PVDF), polyethylene naphtalate (PEN), polyimide (PI), or the like. Second insulating layer 216 may have a thickness in the range of 125 to 350 µm or greater.

According to some embodiments of the back-contact back-sheet according to the present invention not shown in the Figures, intermediate layer 214 is not present. Thus, insulating portion 211 comprises a first insulating layer 212 and a second insulating layer 216 directly applied on the upper surface of the first insulating layer 212, without the presence of intermediate layer 214. According to this embodiment, first insulating layer 212 and second insulating layer 216 comprise the same materials as the first insulating layer 212 and the second insulating layer 216 of the insulating substrate 211 according to the embodiment described above, respectively.

Furthermore, according to further embodiments not shown in the Figures, the insulating portion 211 of the back-contact back-sheet comprises a single insulating layer comprising, for example, one or more polymers such as PET, PE, PVF, PVDF, PEN, PI and the like.

Unlike the back-contact back-sheet 200 described with reference to Figure 3, according to the present invention the inner face of the back-contact back-sheet does not expose the upper surface of second insulating layer 216 or, in general, of insulating portion 211. In other words, the inner surface 210is of substrate 210 upon which conductive material layer 220 is applied does not coincide with the surface of the second insulating layer 216 facing the inside of the photovoltaic module.

According to the present invention and in contrast with the prior art, insulating substrate 210 of the back-contact back-sheet comprises a primer layer 218 arranged between conductive material layer 220 and the second insulating layer 216. In general, primer layer 218 is arranged between conductive material layer 220 and the upper surface of insulating portion 211 of substrate 210, i.e. the surface of portion 211 opposite the surface facing the air-side of the photovoltaic module.

Still with reference to Figure 4, primer layer 218 comprises a lower surface facing the upper surface of insulating portion 211 of substrate 210. Primer layer 218 also comprises an upper surface opposite the lower surface and substantially coincident with the inner surface 210is of substrate 210.

According to an embodiment of the present invention, primer layer 218 has a thickness in the range of 50 to 350 µm. Preferably, primer layer 218 has a thickness in the range of 50 to 150 µm.

Primer layer 218 is applied to insulating portion 211 so as to firmly adhere to the upper surface of the insulating portion 211. Depending on the composition of primer layer 218 (e.g. a polyolefin or a thermo-adhesive), primer layer 218 may be applied to insulating portion 211 by means of an adhesive system or by extrusion coating onto the surface of the insulating portion 211. This extrusion coating process may also be carried out before implementing complex 211.

Primer layer 218 is comprised of materials such as to ensure an improved adhesion of the inner face 200if of the back-contact back-sheet with an encapsulating material foil 400 shown in Figure 1 or a multi-layered structure 1000 such as that shown in Figure 3 adapted to be applied there upon.

Primer layer 218 thus comprises materials which are chemically or functionally akin to the materials constituting the lower encapsulating material layer 400 or lower layer 270 of multi-layered structure 1000.

According to the present invention, primer layer 218 comprises one or more thermo-adhesive materials. According to particular embodiments, the primer layer comprises at least one of the following thermo-adhesive materials: acryl polymers or polyurethanes loaded with additives, acryl terpolymers grafted with maleic anhydride.

According to the present invention, conductive material layer 220 is applied to the inner surface 210is of substrate 210, i.e. to the upper surface of primer layer 218. Since primer layer 218 comprises a thermo-adhesive material, which may have been previously extruded or fixed by an adhesive onto the insulating portion 211, electrically conductive material layer 220 is fixed by simply heating the system comprised of substrate 210 and conductive layer 220. For example, the system can be heated up to temperatures ranging from 80 °C to 140 °C.

It should be noticed that using a thermo-adhesive as a primer layer 218 entails several advantages. A thermo-adhesive may indeed be extruded onto the upper surface of insulating portion 211 and the conductive material layer 220 may be fixed thereupon by simply providing heat to the system, thereby not requiring any adhesives.

Analogously to the case discussed in relation to the back-contact back-sheet 200 shown in Figure 3, conductive material layer 220 of the back-contact back-sheet according to the present invention is adapted to be formed as a connecting circuit 220c to the electrodes of solar cells 600.

The reader is referred to the description given above of the back-contact back-sheet shown in Figure 3 for details concerning techniques and procedures for processing conductive material layer 220 in order to form connecting circuit 220c therein.

According to an embodiment, the present invention proposes a method of producing a back-contact back-sheet with superior features with respect to the back-contact back-sheets known from the state of the art.

The method of producing a back-contact back-sheet according to the present invention begins with preparing and implementing a substrate 210.

More specifically, the step of implementing substrate 210 comprises implementing an insulating portion 211. Insulating portion 211 may comprise one, two or three layers 212, 214, 216, as described above.

Insulating portion 211 of substrate 210 comprises a lower surface, coincident with external surface 210os of substrate 210 and an upper surface opposite the lower surface.

In the second stage of implementing substrate 210, a primer layer 218 is applied to the upper surface of insulating portion 211. This application may be performed by means of extrusion or of an adhesive system. Primer layer 218 has been described above with reference to Figure 4. Primer layer 218 is firmly fixed to the upper surface of insulating portion 211 of substrate 210. The primer layer thus comprises a lower surface facing the upper surface of insulating portion 211 and an upper surface facing the inside of the photovoltaic module and substantially coincident with inner surface 210is of substrate 210.

After substrate 210 has been formed, an electrically conductive material layer 220 is applied to the inner surface 210is of substrate 210. Electrically conductive material layer 220 has been described above with reference to Figures 3 and 4.

According to an embodiment of the present invention, conductive material layer 220 may be fixed to primer layer 218 as a continuous foil. After being firmly fixed to primer layer 218, electrically conductive material 220 is processed so as to form connecting circuit 220c according to one of the known techniques described above.

According to an alternative embodiment, electrically conductive material 220 is processed so as to form connecting circuit 220c before being applied to inner surface 210is of substrate 210. According to this embodiment, conductive material layer 220 is applied and then fixed to the inner surface 210is already in the form of a pre-printed connecting circuit 220c. According to this embodiment, it is preferable that primer layer 218 comprises a thermo-adhesive material.

As said above, the techniques of processing electrically conductive layer 220 may comprise: optical lithography, laser ablation, mechanical ablation and other analogous techniques known to the skilled person.

It should be noticed that, when connecting circuit 220c is formed in conductive material 220 after its application to inner surface 210is of substrate 210, the present invention simplifies the operation of processing conductive material layer 220 in order to form connecting circuit 220c. When connecting circuit 220c is formed in conductive material layer 220 by means of one of the techniques mentioned above or known to the skilled person, through-channels are usually formed in conductive material layer 220, thereby risking of undesirably removing a portion of inner surface 210is of substrate 210 lying immediately below the portion of conductive layer 220 to be perforated. As said above, commonly used perforation techniques can only perforate conductive material layer 220 with a precision of about 1 µm along the transversal direction, i.e. the direction normal to the plain on which the layer lies. Therefore, the portion of inner surface 210is of substrate 210 erroneously removed may have a minimum thickness about 1 µm. According to the present invention, this erroneously removed portion of inner surface 210is comprises a portion of primer layer 218. However, primer layer 218 has a thickness substantially greater than 1 µm and not less than 50 µm. Hence, accidentally removing a thin surface film of primer layer 218 will not have any particularly negative consequences on the following stages of the photovoltaic module assembly process.

After applying conductive material layer 220 to substrate 210 and forming connecting circuit 220c in conductive layer 220, the production process of the back-contact back-sheet shown in Figure 4 is completed.

After the production process has been completed, the back-contact back-sheet according to the present invention has an inner face 200if comprising the surface of connecting circuit 220c exposed toward the inside of the photovoltaic module and the portion of upper surface of primer layer 218 left exposed by connecting circuit 220c.

The back-contact back-sheet according to the present invention may be advantageously used as a constituent part of a photovoltaic module wherein back-contact cells are included. For example, an appropriately pierced encapsulating material foil 400 (Figure 1) or multi-layered structure 1000 (Figure 3) may be applied onto inner face 200if of the back-contact back-sheet. This is then followed by the subsequent stages of the photovoltaic module assembly process described above.

After all layers have been stacked, as shown for example in Figure 2a, the module is hot-laminated. The lamination temperature causes melting of the encapsulating or thermo-adhesive material constituting encapsulating layer 400 or lower layer 270 of multi-layered structure 1000 in contact with inner face 210if of the back-contact back-sheet.

The inner face 210if of the back-contact back-sheet according to the present invention comprises, besides the metallic surface of electrically conductive layer 220, the surface of primer layer 218 left exposed by connecting circuit 220c. Thus, during lamination, the partially molten encapsulating or thermo-adhesive material comes into contact with primer layer 218. The material or material mixture of which primer layer 218 is comprised, are such as to partially melt or soften during the lamination process. On the other hand, primer layer 218 comprises one or more materials which are "compatible with" and "chemically akin to" the encapsulating or thermo-plastic material of the layer lying above the back-contact back-sheet. Therefore, after the system has been laminated and has cooled down, encapsulating layer 400 or multi-layered structure 1000 firmly adhere not only to the surface of connecting circuit 220c, but also to the portion of primer layer 218 left exposed by connecting circuit 220c. The lamination thus causes primer layer 218 and the above-lying encapsulating or thermo-adhesive layer to strongly adhere to each other, thereby resulting in all conductive elements being perfectly embedded in the module.

Adhesion between inner face 200if of the back-contact back-sheet according to the present invention and the encapsulating layer applied thereupon turns out to be considerably improved with respect to the back-contact back-sheet known from the prior art. In particular, the adhesion force is expected to increase from 2 N/cm for the apparatuses known from the state of the art to 40-70 N/cm if a back-contact back-sheet according to one of the embodiments of the present invention is used.

Although the present invention has been described with reference to the embodiments described above, it is clear for a skilled person that it is possible to implement several modifications, variations, and improvements of the present invention in view of the teaching described above and within the scope of the enclosed claims, without departing from the object and the scope of protection of the invention. Furthermore, those areas which are deemed to be known by experts in the field have not been dealt with so as not to unduly obfuscate the described invention. Consequently, the invention is not restricted to the embodiments described above, but it is exclusively limited by the scope of protection of the enclosed claims.

## Claims

1. Back-contact back-sheet for a photovoltaic module comprising back-contact cells, said back-contact back-sheet comprising:
a substrate (210) having an outer surface (210os) exposed toward the air-side of said photovoltaic module and an inner surface (210is) opposite said outer surface (210os) and exposed toward the inside of said photovoltaic module,
a layer (220) of an electrically conductive material adapted to be formed as a connecting circuit (220c) to the electrodes of said solar cells and directly adherent to said inner surface of said substrate (210), said layer of conductive material (220) being firmly fixed to said inner surface (210is) of said substrate (210),
wherein said substrate (210) comprises:
an insulating portion (211) comprising a lower surface facing the air-side of the photovoltaic module and substantially coincident with said outer surface (210os) of said substrate (210) and an upper surface opposite said lower surface,
a primer layer (218) firmly fixed to said upper surface of said insulating portion (211), said primer layer (218) comprising a lower surface facing said upper surface of said insulating portion (211) and an upper surface opposite said lower surface of said primer layer (218) and substantially coincident with said inner surface (210is) of said substrate (210),
**characterized in that:**
said primer layer (218) comprises a thermo-adhesive material, wherein said conductive material layer (220) is fixed to said primer layer (218) by means of heat so that no adhesives are present between said conductive material layer (220) and said primer layer (218).

2. Back-contact back-sheet according to claim 1, wherein said thermo-adhesive material is one of: acryl copolymers, polyurethanes loaded with additives, or acryl terpolymers grafted with maleic anhydride.

3. Back-contact back-sheet according to one of claims 1 or 2 wherein said insulating portion (211) of said substrate (210) comprises at least one of the following materials: polyethylene terephthalate (PET), polyethylene (PE), polyvinyl fluoride (PVF), polyvinylidene fluoride (PVDF), polyethylene naphthalate (PEN), polyimide (PI) Kapton®.

4. Back-contact back-sheet according to one of claims 1 to 3 wherein said insulating portion (211) comprises:
a first insulating layer (212) of a first polymeric material having an outer surface facing the air-side of said photovoltaic module and an inner surface opposite said outer surface,
an intermediate layer (214) of a material impermeable to water vapour coupled to said inner surface of said first insulating layer (212), said intermediate layer having a lower surface facing said first insulating layer (212) and an upper surface opposite said lower surface,
a second insulating layer (216) of a second polymeric material coupled to said upper surface of said intermediate layer (214).

5. Back-Contact back-sheet according to one of claims 1 to 3, wherein said insulating portion (211) comprises:
a first insulating layer (212) of a first polymeric material having an outer surface facing the air-side of said photovoltaic module and an inner surface opposite said outer surface, and
a second insulating layer (216) of a second polymeric material applied onto said inner surface of said first insulating layer (212).

6. Back-Contact back-sheet according to one of claims 1 to 5, wherein said layer of electrically conductive material (220) comprises a metal with a high electrical conductivity such as copper or aluminium.

7. Method of producing a back-contact back-sheet for a photovoltaic module comprising back-contact solar cells, said method comprising:
making a substrate (210) having an outer surface (210os) exposed toward the air-side of said photovoltaic module and an inner surface (210is) opposite said outer surface and exposed toward the inside of said photovoltaic module,
applying to said substrate (210) a layer of electrically conductive material (220) adapted to be formed as a connecting circuit (220c) to the electrodes of said solar cells, said application being performed in such a way that said layer of electrically conducting material (220) fixedly adheres to said inner surface (210is) of said substrate (210),
said method being such that said step of making said substrate (210) comprises:
making an insulating portion (211) comprising a lower surface facing the air-side of the photovoltaic module and substantially coincident with said outer surface (210os) of said substrate (210) and an upper surface opposite said lower surface,
applying and fixing a primer layer (218) to said upper surface of said insulating portion (211), said step of applying and fixing said primer layer (218) being performed in such a way that said primer layer (218) comprises a lower surface facing said upper surface of said insulating portion (211) and an upper surface opposite said lower surface of said primer layer (218) and substantially coincident with said inner surface (210is) of said substrate (210),
**characterized in that:**
said primer layer (218) comprises a thermo-adhesive material, wherein said layer of electrically conductive material (220) is fixed to said inner surface (210is) of said substrate (210) by heating so that no adhesives are present between said conductive material layer (220) and said primer layer (218).

8. Method according to claim 7, wherein said heating is performed at temperatures ranging from 80°C to 140°C.

9. Method according to any of claims 7 or 8, wherein said thermo-adhesive material is one of: acryl copolymers, polyurethanes loaded with additives, or acryl terpolymers grafted with maleic anhydride.

10. Method according to any of claims 7 to 9, wherein said step of applying and fixing said primer layer (218) comprises extrusion coating said upper surface of said insulating portion (211) with said primer layer (218).

11. Method according to any of claims 7 to 10, wherein said step of applying and fixing said primer layer (218) comprises using an adhesive system between said primer layer (218) and said insulating portion (211).

12. Method according to one of claims 7 to 11 further comprising processing said layer of electrically conductive material (220) so as to form said connecting circuit (220c).

13. Method according to claim 12 wherein said step of processing said layer of electrically conductive material (220) is performed after said step of applying said layer of electrically conductive material (220) to said inner surface (210is) of said substrate (210).

14. Method according to claim 12 wherein said step of processing said layer of electrically conductive material (220) is performed before said step of applying said layer of electrically conductive material (220) to said inner surface (210is) of said substrate (210).

## Patentansprüche

1. Rückkontakt-Rückseitenfolie für ein Photovoltaikmodul mit Rückkontaktzellen, wobei die Rückkontakt-Rückseitenfolie umfasst:
ein Substrat (210) mit einer zu der Luftseite des Photovoltaikmoduls hin freiliegenden Außenoberfläche (210os) und einer Innenoberfläche (210is) gegenüber der Außenoberfläche (210os), die zu der Innenseite des Photovoltaikmoduls hin offen ist,
eine Schicht (220) aus einem elektrisch leitfähigen Material, die als Verbindungsschaltung (220c) mit den Elektroden der Solarzellen ausgebildet werden kann und direkt an der Innenoberfläche des Substrats (210) haftet, wobei die Schicht aus leitfähigem Material fest an der Innenoberfläche (210is) des Substrats (210) befestigt ist,
wobei das Substrat (210) umfasst:
einen Isolierabschnitt (211), der eine Unterseite aufweist, die der Luftseite des Photovoltaikmoduls zugewandt ist und im wesentlichen mit der Außenoberfläche (210os) des Substrats (210) und einer Oberseite gegenüber der Unterseite zusammenfällt,
eine Grundierschicht (218), die fest an der Oberseite des Isolierabschnitts (211) befestigt ist, wobei die Grundierschicht (218) eine Unterseite, die der Oberseite des Isolierabschnitts (211) zugewandt ist, und eine Oberseite umfasst, die der Unterseite der Grundierschicht (218) gegenüberliegt und im wesentlichen mit der Innenoberfläche (210is) des Substrats (210) übereinstimmt,
**dadurch gekennzeichnet, dass**:
die Grundierschicht (218) ein thermisch haftendes Material aufweist, wobei die leitfähige Materialschicht (220) an der Grundierschicht (218) mittels Wärme fixiert ist, so dass keine Haftmittel zwischen der leitfähigen Materialschicht (220) und Grundierschicht (218) vorhanden sind.

2. Rückkontakt-Rückseitenfolie nach Anspruch 1, bei der es sich bei dem thermisch anhaftenden Material um Acrylcopolymere, mit Additiven angereicherte Polyurethane oder mit Maleinsäureanhydrid aufpolymerisierte Acrylterpolymere handelt.

3. Rückkontakt-Rückseitenfolie nach einem der Ansprüche 1 oder 2, bei der der Isolierabschnitt (211) des Substrats (210) wenigstens eines der folgenden Materialien umfasst: Polyethylenterephthalat (PET), Polyethylen (PE) Fluorid (PVF), Polyvinylidenfluorid (PVDF), Polyethylennaphthalat (PEN), Polyimid (PI) Kapton®.

4. Rückkontakt-Rückseitenfolie nach einem der Ansprüche 1 bis 3, bei der der Isolierabschnitt (211) umfasst:
eine erste Isolierschicht (212) aus einem ersten Polymermaterial mit einer der Luftseite des Photovoltaikmoduls zugewandten Außenoberfläche und einer der Außenoberfläche gegenüberliegenden Innenoberfläche,
eine Zwischenschicht (214) aus einem für Wasserdampf undurchlässigen Material, das mit der Innenoberfläche der ersten Isolierschicht (212) gekoppelt ist, wobei die Zwischenschicht eine der ersten Isolierschicht (212) zugewandte Unterseite und eine der Unterseite gegenüberliegende Oberseite hat, und
eine zweite Isolierschicht (216) aus einem zweiten Polymermaterial, die mit der Oberseite der Zwischenschicht (214) gekoppelt ist.

5. Rückkontakt-Rückseitenfolie nach einem der Ansprüche 1 bis 3, bei der der Isolierabschnitt (211) umfasst:
eine erste Isolierschicht (212) aus einem ersten Polymermaterial mit einer der Luftseite des Photovoltaikmoduls zugewandten Außenoberfläche und einer der Außenoberfläche gegenüberliegenden Innenoberfläche und
eine zweite Isolierschicht (216) aus einem zweiten Polymermaterial, die auf die Innenoberfläche der ersten Isolierschicht (212) aufgebracht ist.

6. Rückkontakt-Rückseitenfolie nach einem der Ansprüche 1 bis 5, bei der die Schicht aus elektrisch leitfähigem Material (220) ein Metall mit einer hohen elektrischen Leitfähigkeit wie Kupfer oder Aluminium aufweist.

7. Verfahren für die Herstellung einer Rückkontakt-Rückseitenfolie für ein PhotovoltaikModul mit Rückkontakt-Solarzellen, wobei das Verfahren umfasst:
Herstellen eines Substrats (210) mit einer Außenoberfläche (210os), die zur Luftseite des Photovoltaikmoduls freiliegt, und einer Innenoberfläche (210is), die der Außenoberfläche gegenüberliegt und zur Innenseite des Photovoltaikmoduls hin freiliegt,
Aufbringen einer Schicht aus elektrisch leitfähigem Material (220), die als Verbindungsschaltung (220c) zu den Elektroden der Solarzellen ausgebildet werden kann, auf das Substrat (210), wobei das Aufbringen so ausgeführt wird, dass die Schicht aus elektrisch leitfähigem Material (220) fest an der Innenoberfläche (210is) des Substrats (210) haftet,
wobei das Verfahren derart beschaffen ist, dass der Schritt des Herstellens des Substrats (210) umfasst:
Herstellen eines Isolierabschnitts (211), der eine Unterseite, die der Luftseite des Photovoltaikmoduls zugewandt ist und im wesentlichen mit der Außenoberfläche (210os) des Substrats (210) übereinstimmt, und eine Oberseite gegenüber der Unterseite aufweist,
Auftragen und Fixieren einer Grundierschicht (218) auf der Oberseite des Isolierabschnitts (211), wobei der Schritt des Aufbringens und Fixierens der Grundierschicht (218) so durchgeführt wird, dass die Grundierschicht (218) eine Unterseite, die der Oberseite des Isolierabschnitts (211) zugewandt ist, und eine Oberseite umfasst, die der Unterseite der Grundierschicht (218) gegenüberliegt und im wesentlichen mit der Innenoberfläche (210is) des Substrats (210) übereinstimmt,
**dadurch gekennzeichnet, dass**:
die Grundierschicht (218) ein thermisch haftendes Material aufweist, wobei die Schicht aus elektrisch leitfähigem Material (220) an der Innenoberfläche (210is) des Substrats (210) durch Erhitzen befestigt wird, so dass keine Haftmittel zwischen der leitfähigen Materialschicht (220) und der Grundierschicht (218) vorhanden sind.

8. Verfahren nach Anspruch 7, bei dem das Erwärmen bei Temperaturen im Bereich von 80° C bis 140° C durchgeführt wird.

9. Verfahren nach einem der Ansprüche 7 oder 8, bei dem das thermisch haftende Material aus Acrylcopolymeren, mit Additiven angereicherten Polyurethanen oder mit Maleinsäureanhydrid aufpolymerisierten Acrylterpolymeren besteht.

10. Verfahren nach einem der Ansprüche 7 bis 9, bei dem der Schritt des Aufbringens und Fixierens der Grundierschicht (218) das Extrusionsbeschichten der Oberseite des Isolierabschnitts (211) mit der Grundierschicht (218) umfasst.

11. Verfahren nach einem der Ansprüche 7 bis 10, bei dem der Schritt des Aufbringens und Fixierens der Grundierschicht (218) das Verwenden eines Haftsystems zwischen der Grundierschicht (218) und dem Isolierabschnitt (211) umfasst.

12. Verfahren nach einem der Ansprüche 7 bis 11, weiterhin umfassend das Verarbeiten der Schicht aus elektrisch leitfähigem Material (220), um die Verbindungsschaltung (220c) auszubilden.

13. Verfahren nach Anspruch 12, bei dem der Schritt des Verarbeitens der Schicht aus elektrisch leitfähigem Material (220) nach dem Schritt des Aufbringens der Schicht aus elektrisch leitfähigem Material (220) auf die Innenoberfläche (210is) des Substrats (210) ausgeführt wird.

14. Verfahren nach Anspruch 12, bei dem der Schritt des Verarbeitens der Schicht aus elektrisch leitfähigem Material (220) vor dem Schritt des Aufbringens der Schicht aus elektrisch leitfähigem Material (220) auf die Innenoberfläche (210is) des Substrats (210) ausgeführt wird.

## Revendications

1. Feuille de support à contact arrière pour un module photovoltaïque comprenant des cellules à contact arrière, ladite feuille de support à contact arrière comprenant :
un substrat (210) comportant une surface externe (210os) exposée du côté air dudit module photovoltaïque et une surface interne (210is) opposée à ladite surface externe (210os) et exposée vers l'intérieur dudit module photovoltaïque,
une couche (220) de matériau électriquement conducteur conçue pour être formée comme circuit de raccordement (220c) aux électrodes desdites cellule solaires et adhérant directement à ladite surface interne dudit substrat (210), ladite couche (220) de matériau conducteur étant solidement fixée à ladite surface interne (210is) dudit substrat (210),
dans laquelle ledit substrat (210) comprend :
une partie isolante (211) comprenant une surface inférieure faisant face au côté air du module photovoltaïque et coïncidant pratiquement à ladite surface externe (210os) dudit substrat (210), ainsi qu'une surface supérieure opposée à ladite surface inférieure,
une couche de fond (218) solidement fixée à ladite surface supérieure de ladite partie isolante (211), ladite couche de fond (218) comprenant une surface inférieure faisant face à ladite surface supérieure de ladite partie isolante (211), ainsi qu'une surface supérieure opposée à ladite surface inférieure de ladite couche de fond (218) et coïncidant pratiquement avec ladite surface interne (210is) dudit substrat (210),
**caractérisée en ce que**
ladite couche de fond (218) comprend un matériau thermo adhésif, ladite couche (220) de matériau conducteur étant fixée à ladite couche de fond (218) au moyen de la chaleur de sorte à ce qu'aucun adhésif ne soit présent entre ladite couche (220) de matériau conducteur et ladite couche de fond (218).

2. Feuille de support à contact arrière selon la revendication 1, dans laquelle ledit matériau thermo adhésif est l'un parmi : des copolymères acryliques, des polyuréthanes chargés avec des additifs ou des terpolymères acryliques greffés avec de l'anhydride malique.

3. Feuille de support à contact arrière selon la revendication 1 ou la revendication 2, dans laquelle ladite partie isolante (211) dudit substrat (210) comprend au moins l'un des matériaux suivants : polyéthylène téréphtalate (PET), polyéthylène (PE), polyfluorure de vinyle (PVF), polyfluorure de vinylidène (PVDF), polynaphtalate d'éthylène (PEN), polyimide (PI) Kapton ®.

4. Feuille de support à contact arrière selon l'une des revendications 1 à 3, dans laquelle ladite partie isolante (211) comprend :
une première couche isolante (212) d'un premier matériau polymère dont la surface externe fait face au côté air dudit module photovoltaïque et dont la surface interne est opposée à ladite surface externe,
une couche intermédiaire (214) d'un matériau imperméable à la vapeur d'eau, couplé à ladite surface interne de ladite première couche isolante (212), ladite couche intermédiaire ayant sa surface inférieure faisant face à ladite première couche isolante (212) et sa surface supérieure opposée à ladite surface inférieure,
une seconde couche isolante (216) d'un second matériau polymère couplé à ladite surface supérieure de ladite couche intermédiaire (214).

5. Feuille de support à contact arrière selon l'une des revendications 1 à 3, dans laquelle ladite partie isolante (211) comprend :
une première couche isolante (212) d'un premier matériau polymère dont la surface externe fait face au côté air dudit module photovoltaïque et dont la surface interne est opposée à ladite surface externe, et
une seconde couche isolante (216) d'un second matériau polymère appliqué sur ladite surface interne de ladite première couche isolante (212).

6. Feuille de support à contact arrière selon l'une des revendications 1 à 5, dans laquelle ladite couche (220) de matériau électriquement conducteur comprend un métal présentant une conductivité électrique élevée tel que le cuivre ou l'aluminium.

7. Procédé de fabrication d'une feuille de support à contact arrière pour un module photovoltaïque comprenant des cellules solaires à contact arrière, ledit procédé comprenant :
la réalisation d'un substrat (210) comportant une surface externe (210os) exposée du côté air dudit module photovoltaïque et une surface interne (210is) opposée à ladite surface externe et exposée vers l'intérieur dudit module photovoltaïque,
l'application au dit substrat (210) d'une couche (220) de matériau électriquement conducteur conçue pour être formée comme circuit de raccordement (220c) aux électrodes desdites cellule solaires, ladite application étant effectuée de sorte à ce que ladite couche (220) de matériau électriquement conducteur adhère solidement à ladite surface interne (210is) dudit substrat (210),
ledit procédé étant tel que ladite étape de réalisation dudit substrat (210) comprend :
la réalisation d'une partie isolante (211) comprenant une surface inférieure faisant face au côté air du module photovoltaïque et coïncidant pratiquement à ladite surface externe (210os) dudit substrat (210), ainsi qu'une surface supérieure opposée à ladite surface inférieure,
l'application et la fixation d'une couche de fond (218) à ladite surface supérieure de ladite partie isolante (211), ladite étape d'application de fixation de ladite couche de fond (218) étant effectuée de sorte à ce que ladite couche de fond (218) comprend une surface inférieure faisant face à ladite surface supérieure de ladite partie isolante (211), ainsi qu'une surface supérieure opposée à ladite surface inférieure de ladite couche de fond (218) et coïncidant pratiquement avec ladite surface interne (210is) dudit substrat (210),
**caractérisé en ce que**
ladite couche de fond (218) comprend un matériau thermo adhésif, ladite couche (220) de matériau électriquement conducteur étant fixée à ladite surface interne (210is) dudit substrat (210) par chauffage de sorte à ce qu'aucun adhésif ne soit présent entre ladite couche (220) de matériau conducteur et ladite couche de fond (218) .

8. Procédé selon la revendication 7, dans lequel ledit chauffage est effectué à des températures comprises entre 80 °C et 140 °C.

9. Procédé selon la revendication 7 ou la revendication 8, dans lequel ledit matériau thermo adhésif est l'un parmi : des copolymères acryliques, des polyuréthanes chargés avec des additifs ou des terpolymères acryliques greffés avec de l'anhydride malique.

10. Procédé selon l'une quelconque des revendications 7 à 9, dans lequel ladite étape d'application et de fixation de ladite couche de fond (218) comprend le couchage par extrusion de ladite surface supérieure de ladite partie isolante (211) avec ladite couche de fond (218).

11. Procédé selon l'une quelconque des revendications 7 à 10, dans lequel ladite étape d'application et de fixation de ladite couche de fond (218) comprend l'utilisation d'un système d'adhésif entre ladite couche de fond (218) et ladite partie isolante (211).

12. Procédé selon l'une quelconque des revendications 7 à 11, comprenant en outre le traitement de ladite couche (220) de matériau électriquement conducteur de sorte à former ledit circuit de raccordement (220c).

13. Procédé selon la revendication 12, dans lequel ladite étape de traitement de ladite couche (220) de matériau électriquement conducteur est effectuée après ladite étape d'application de ladite couche (220) de matériau électriquement conducteur sur ladite surface interne (210is) dudit substrat (210).

14. Procédé selon la revendication 12, dans lequel ladite étape de traitement de ladite couche (220) de matériau électriquement conducteur est effectuée avant ladite étape d'application de ladite couche (220) de matériau électriquement conducteur sur ladite surface interne (210is) dudit substrat (210).
